# EUROPEAN PATENT APPLICATION

(11) **EP 4 790 743 A1**
(43) Date of publication of application: **12.08.2026**
(21) Application number: 24874288.4
(22) Date of filing: 28.03.2024
(51) Int. Cl.: H01L 21/318, C23C 16/455, H01L 21/31, H01L 21/316

(54) **SUBSTRATE PROCESSING METHOD, METHOD FOR PRODUCING SEMICONDUCTOR DEVICE, PROGRAM, AND SUBSTRATE PROCESSING DEVICE**

(30) Priority: 03.10.2023 JP 2023171884
(71) Applicant: Kokusai Electric Corporation, Tokyo 100-0004 (JP)
(72) Inventor: NOHARA, Shingo, Toyama-shi, Toyama 939-2393 (JP); OZAKI, Takashi, Toyama-shi, Toyama 939-2393 (JP); ISHIBASHI, Kiyohisa, Toyama-shi, Toyama 939-2393 (JP); EBATA, Shinya, Toyama-shi, Toyama 939-2393 (JP); SHIMURA, Jumpei, Toyama-shi, Toyama 939-2393 (JP); TSUGAOKA, Yasunori, Toyama-shi, Toyama 939-2393 (JP)
(74) Representative: Bardehle Pagenberg Partnerschaft mbB Patentanwälte Rechtsanwälte
(86) International application number: PCT/JP2024/012790
(87) International publication number: WO 2025/074669

(57) **Abstract**

The present disclosure improves the characteristics of a film formed on a substrate. The present disclosure includes: (a) a step in which a raw material is supplied to a substrate; (b) a step in which a reactant is supplied to the substrate; (c) a step in which a regulating agent is supplied to the substrate to regulate the amount of at least one of the molecules of the raw material and the molecules of the reactant adsorbed to the substrate; (d) a step in which at least one of (a) and (b) is performed in an overlapping manner with (c); and (e) a step in which following (d), (a) or (b) that was performed in an overlapping manner with (c) in (d) is performed independently from (c).

## Description

### TECHNICAL FIELD

The present disclosure relates to a method of processing a substrate, a method of manufacturing a semiconductor device, a program, and a substrate processing apparatus.

### BACKGROUND

As a process of manufacturing a semiconductor device, a substrate processing process may be performed in which a precursor gas and a reaction gas are supplied to a substrate to form a film on the substrate (*see*, e.g., Japanese laid-open publication No. 2014-135475).

### [Prior Art Document]

### Patent Document

Patent Document 1: Japanese laid-open publication No. 2014-135475

### SUMMARY

The present disclosure provides some embodiments of a technique capable of improving characteristics of a film formed on a substrate.

According to some embodiments of the present disclosure, there is provided a technique that includes: (a) supplying a precursor to a substrate; (b) supplying a reactant to the substrate; (c) supplying a regulating agent, which regulates an amount of at least one selected from the group of a molecule of the precursor and a molecule of the reactant adsorbed on the substrate, to the substrate; (d) performing a process in which at least one selected from the group of (a) and (b) overlaps (c); and (e) after (d), performing (a) or (b) which overlaps (c) in (d), independently of (c).

According to the embodiments of the present disclosure, it is possible to provide a technique capable of improving characteristics of a film formed on a substrate.

### BRIEF DESCRIPTION OF DRAWINGS

FIG. 1 is a vertical sectional view showing an outline of a vertical process furnace of a substrate processing apparatus according to some embodiments of the present disclosure.
FIG. 2 is a schematic cross-sectional view taken along line A-A in FIG. 1.
FIG. 3 is a schematic configuration diagram of a controller of a substrate processing apparatus according to some embodiments of the present disclosure, in which a control system of the controller is shown in a block diagram.
FIG. 4 is a diagram showing an example of a substrate processing process according to some embodiments of the present disclosure.
FIG. 5 is a diagram showing an example of the substrate processing process according to some embodiments of the present disclosure.

### DETAILED DESCRIPTION

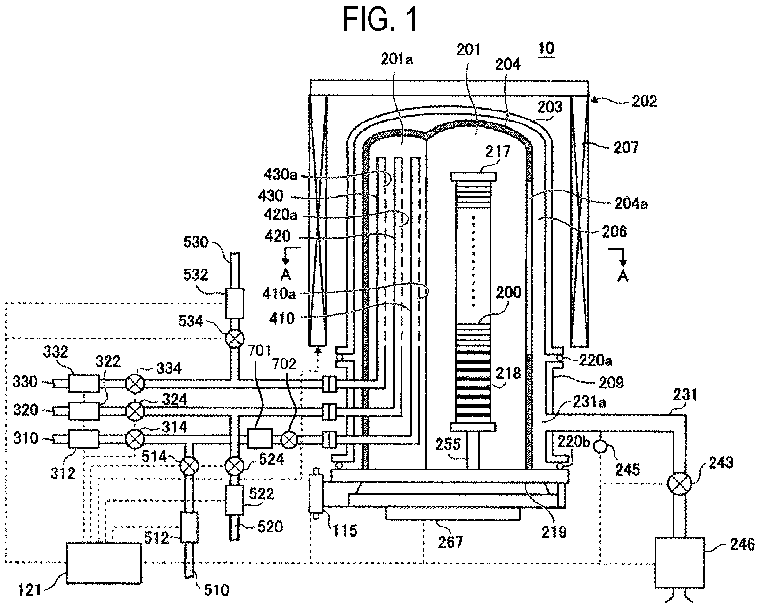

Hereinafter, descriptions will be made with reference to FIGS. 1 to 5. The drawings used in the following description are schematic, and dimensional relationships, ratios, and the like of the respective elements shown in the drawings may not match actual ones. Further, dimensional relationships, ratios, and the like of the respective elements among plural drawings may not match each other.

### (1) Configuration of Substrate Processing Apparatus

A substrate processing apparatus 10 includes a process furnace 202 provided with a heater 207 as a heating means or unit (a heating mechanism or a heating system). The heater 207 is formed in a cylindrical shape and is vertically installed by being supported by a heater base (not shown) as a holding plate.

Inside the heater 207, an outer tube 203 constituting a reaction tube (a reaction container or a process container) is arranged concentrically with the heater 207. The outer tube 203 is made of, for example, a heat-resistant material such as quartz or silicon carbide (SiC), and is formed in a cylindrical shape with its upper end closed and lower end opened. Below the outer tube 203, a manifold 209 (hereinafter, referred to as MF 209) is arranged concentrically with the outer tube 203. The MF 209 is made of, for example, a metal such as stainless steel (SUS) or the like, and is formed in a cylindrical shape with its upper end and lower end opened. An O-ring 220a as a seal is installed between the upper end of the MF 209 and the outer tube 203. By supporting the MF 209 on the heater base, the outer tube 203 is installed vertically.

Inside the outer tube 203, an inner tube 204 constituting a reaction container is arranged. The inner tube 204 is made of, for example, a heat-resistant material such as quartz or SiC, and is formed in a cylindrical shape with its upper end closed and lower end opened. A process container (reaction container) mainly includes the outer tube 203, the inner tube 204, and the MF 209. A process chamber 201 is formed in a hollow cylindrical area of the process container (inside the inner tube 204).

The process chamber 201 is configured to be capable of accommodating wafers 200 as substrates in such a state that the wafers 200 are arranged in a horizontal posture and in multiple stages along a vertical direction by a boat 217 as a support.

Nozzles 410, 420, and 430 are installed in the process chamber 201 so as to penetrate a side wall of the MF 209 and the inner tube 204. Gas supply pipes 310, 320, and 330 are connected to the nozzles 410, 420, and 430, respectively. However, the process furnace 202 of the embodiments of the present disclosure is not limited to the above-described embodiment.

Mass flow controllers (MFCs) 312, 322, and 332, which are flow rate controllers (flow rate control parts) are installed at the gas supply pipes 310, 320, and 330, respectively, sequentially from the upstream side. Further, valves 314, 324, and 334, which are on-off valves, are installed at the gas supply pipes 310, 320, and 330, respectively. Gas supply pipes 510, 520, and 530 configured to supply an inert gas are connected to the gas supply pipes 310, 320, and 330, respectively, on the downstream side of the valves 314, 324, and 334, respectively. At the gas supply pipes 510, 520, and 530, MFCs 512, 522, and 532, which are flow rate controllers (flow rate control parts), and valves 514, 524, and 534, which are on-off valves, are installed sequentially from the upstream side, respectively.

Nozzles 410, 420, and 430 are connected to tips of the gas supply pipes 310, 320, and 330, respectively. The nozzles 410, 420, and 430 are constituted as L-shaped nozzles, and horizontal portions thereof are provided so as to penetrate the side wall of the MF 209 and the inner tube 204. Vertical portions of the nozzles 410, 420, and 430 are installed inside a channel-shaped (groove-shaped) spare chamber 201a formed to protrude outward in a radial direction of the inner tube 204 and to extend in the vertical direction. Furthermore, the vertical portions of the nozzles 410, 420, and 430 are installed in the spare chamber 201a so as to extend upward (toward an upper side in an arrangement direction of the wafers 200) along an inner wall of the inner tube 204.

The nozzles 410, 420, and 430 are installed so as to extend from a lower region to an upper region of the process chamber 201. A plurality of gas supply holes 410a, 420a, and 430a are formed at the nozzles 410, 420, and 430 so as to face the wafers 200 respectively. As a result, processing gases are supplied to the wafers 200 from the gas supply holes 410a, 420a, and 430a of the nozzles 410, 420, and 430, respectively. The plurality of gas supply holes 410a, 420a, and 430a are provided from a lower side to an upper side of the inner tube 204. Further, the gas supply holes 410a, 420a, and 430a have the same opening area. Further, the gas supply holes 410a, 420a, and 430a are arranged at the same pitch. However, the gas supply holes 410a, 420a, and 430a are not limited to the above-mentioned form. For example, opening areas of the gas supply holes 410a, 420a, and 430a may be gradually increased from the lower side to the upper side of the inner tube 204. This makes it possible to make flow rates of the gases supplied from the gas supply holes 410a, 420a, and 430a to the wafers 200 more uniform.

The gas supply holes 410a, 420a, and 430a of the nozzles 410, 420, and 430 are provided over a region from a lower side to an upper side of the boat 217. Therefore, the processing gases supplied into the process chamber 201 from the gas supply holes 410a, 420a, and 430a of the nozzles 410, 420, and 430 are supplied to entire areas of the wafers 200 accommodated from the lower side to the upper side of the boat 217. The nozzles 410, 420, and 430 may be installed so as to extend from the lower region to the upper region of the process chamber 201. Specifically, the nozzles 410, 420, and 430 may be installed so as to extend to the vicinity of a ceiling of the boat 217.

A precursor as a processing gas is supplied from the gas supply pipe 310 into the process chamber 201 via the MFC 312, the valve 314, and the nozzle 410. In the present disclosure, the precursor is also referred to as a precursor agent or a source.

A reactant as a processing gas is supplied from the gas supply pipe 320 into the process chamber 201 via the MFC 322, the valve 324, and the nozzle 420. In the present embodiment, the reactant is also referred to as a reaction agent and reactant.

A regulating agent that, unlike the reactant, inhibits adsorption of elements contained in the precursor is supplied as a processing gas from the gas supply pipe 330 into the process chamber 201 via the MFC 332, the valve 334, and the nozzle 430. In the present disclosure, the regulating agent is also referred to as a modifying agent, an adsorption suppressant, a reaction inhibitor, or a surface regulating agent.

In the present disclosure, the term "agent" as used herein includes at least one selected from the group of a gaseous substance and a liquid substance. The liquid substance includes a mist substance. That is, the regulating agent may include a gaseous substance, may include a liquid substance such as a mist substance, or may include both of them. In addition, in a case where the precursor, the reactant, and the regulating agent include the gaseous substances, they may be referred to as a precursor gas, a reaction gas, and a regulating gas, respectively.

An inert gas, for example, a nitrogen (N₂) gas, is supplied from the gas supply pipes 510, 520, and 530 into the process chamber 201 via the MFCs 512, 522, and 532, the valves 514, 524, and 534, and the nozzles 410, 420, and 430, respectively. Hereinafter, an example in which the N₂ gas is used as the inert gas will be described. However, as the inert gas, for example, a rare gas such as an Ar gas, a He gas, a Ne gas, or a Xe gas may be used in addition to the N₂ gas.

When the precursor flows through the gas supply pipe 310, a precursor supply system (a first gas supply system) mainly includes the gas supply pipe 310, the MFC 312, and the valve 314. The nozzle 410 may be included in the precursor supply system. When the reactant flows through the gas supply pipe 320, a reactant supply system (a third gas supply system) mainly includes the gas supply pipe 320, the MFC 322, and the valve 324. The nozzle 420 may be included in the reactant supply system. When the regulating agent flows through the gas supply pipe 330, a regulating agent supply system (a second gas supply system) mainly includes the gas supply pipe 330, the MFC 332, and the valve 334. The nozzle 430 may be included in the regulating agent supply system. Further, the precursor supply system, the reactant supply system, and the regulating agent supply system may also be referred to as processing gas supply systems. The nozzles 410, 420, and 430 may be included in the processing gas supply systems. In addition, an inert gas supply system mainly includes the gas supply pipes 510, 520, and 530, the MFCs 512, 522, and 532, and the valves 514, 524, and 534.

At the gas supply pipe 310, a storage 701 configured to store a processing gas, and a valve 702 on a rear side of the storage 701 (on the side of the process chamber 201) may be installed.

In the embodiments of the present disclosure, gases are conveyed into the inner tube 204 via the nozzles 410, 420, and 430 arranged in the spare chamber 201a of a vertically elongated annular space defined by the inner wall of the inner tube 204 and ends of the plurality of wafers 200. Then, the gases are discharged into the inner tube 204 from the plurality of gas supply holes 410a, 420a, and 430a provided at the positions of the nozzles 410, 420, and 430 facing the wafers 200. More specifically, the precursor and the like are discharged in the direction parallel to surfaces of the wafers 200 from the gas supply holes 410a of the nozzle 410, the gas supply holes 420a of the nozzle 420, and the gas supply holes 430a of the nozzle 430.

An exhaust hole (exhaust port) 204a is a through-hole formed at a position facing the nozzles 410, 420, and 430 on the side wall of the inner tube 204, and is, for example, a slit-shaped through-hole elongated in the vertical direction. The gas supplied into the process chamber 201 from the gas supply holes 410a, 420a, and 430a of the nozzles 410, 420, and 430 and flowing on the surfaces of the wafers 200 passes through the exhaust hole 204a and flows through a gap (exhaust path 206) defined between the inner tube 204 and the outer tube 203. Then, the gas flowing through the exhaust path 206 is allowed to flow through the exhaust pipe 231 and is discharged to the outside of the process furnace 202.

The exhaust hole 204a is provided at the position facing the plurality of wafers 200. The gas supplied from the gas supply holes 410a, 420a, and 430a to the vicinity of the wafers 200 in the process chamber 201 flows in the horizontal direction and then flows through the exhaust path 206 via the exhaust hole 204a. The exhaust hole 204a is not limited to the slit-shaped through-hole, and may be constituted by a plurality of holes.

An exhaust pipe 231 configured to exhaust an atmosphere in the process chamber 201 is connected to an exhaust port 231a installed at the manifold 209. A pressure sensor 245 as a pressure detector (a pressure detection part) configured to detect an internal pressure of the process chamber 201, an auto pressure controller (APC) valve 243, and a vacuum pump 246 as a vacuum exhauster are sequentially connected to the exhaust pipe 23 from the upstream side. By opening or closing the APC valve 243 while operating the vacuum pump 246, it is possible to perform or stop a vacuum exhaust operation in the process chamber 201. Further, the APC valve 243 is configured to be capable of regulating the internal pressure of the process chamber 201 by adjusting a degree of valve opening while operating the vacuum pump 246, it is possible to regulate the pressure in the process chamber 201. An exhaust system mainly includes the exhaust hole 204a, the exhaust path 206, the exhaust pipe 231, the APC valve 243, and the pressure sensor 245. The vacuum pump 246 may be included in the exhaust system.

A seal cap 219 (hereinafter, referred to as SC 219), which serves as a furnace opening lid configured to be capable of hermetically sealing a lower end opening of the MF 209, is installed under the MF 209. The SC 219 is configured to be in contact with the lower end of the MF 209 from a lower side in the vertical direction. The SC 219 is made of, for example, a metal such as SUS or the like, and is formed in a disc shape. An O-ring 220b as a seal making contact with the lower end of the MF 209 is installed on an upper surface of the SC 219. On the opposite side of the SC 219 from the process chamber 201, a rotator 267 configured to rotate the boat 217 configured to accommodate the wafers 200 is installed. The rotary shaft 255 of the rotator 267 penetrates the SC 219 and is connected to the boat 217. The rotator 267 is configured to rotate the wafers 200 by rotating the boat 217. The SC 219 is configured to be raised or lowered in the vertical direction by a boat elevator 115 (hereinafter, referred to as BE 115) as an elevator vertically installed outside the outer tube 203. The BE 115 is configured to be capable of loading or unloading the boat 217 into or from the process chamber 201 by raising or lowering the SC 219. The BE 115 is constituted as a transfer apparatus (a transfer mechanism or a transfer system) configured to transfer the boat 217 and the wafers 200, which are accommodated in the boat 217, into or out of the process chamber 201.

The boat 217 is configured to arrange a plurality of wafers, for example, 25 to 200 wafers 200, in such a state that wafers 200 are arranged in a horizontal posture and at intervals in the vertical direction with centers of the wafers 200 aligned with each other. The boat 217 is made of, for example, a heat-resistant material such as quartz or SiC. At a lower side of the boat 217, dummy substrates 218 made of, for example, a heat-resistant material such as quartz or SiC are installed in a horizontal posture and in multiple stages. According to this configuration, heat from the heater 207 is less likely to be transferred to the SC 219. However, the embodiments of the present disclosure is not limited to the above-described form. For example, instead of installing the dummy substrates 218 at the lower side of the boat 217, a heat insulating tube constituted as a tubular member made of a heat-resistant material such as quartz or SiC may be installed.

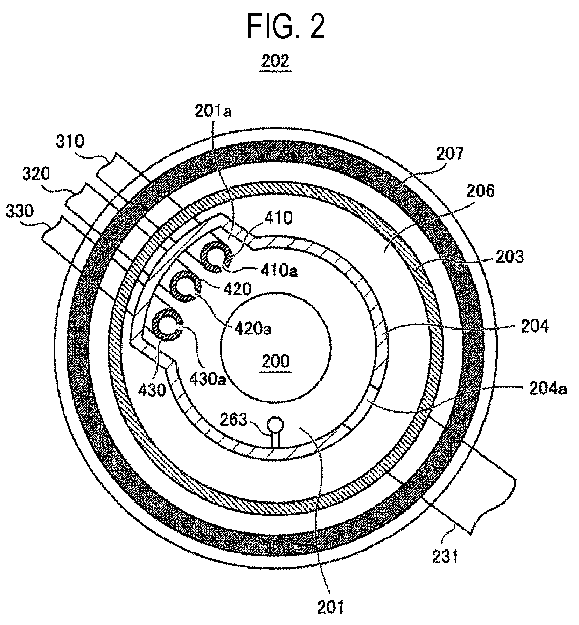

As shown in FIG. 2, a temperature sensor 263 as a temperature detector is installed in the inner tube 204. In the substrate processing apparatus 10, an amount of electric power supplied to the heater 207 is regulated based on temperature information detected by the temperature sensor 263, such that a temperature distribution in the process chamber 201 becomes a desired temperature distribution. The temperature sensor 263 is formed in an L shape similar to the nozzles 410, 420, and 430, and is installed along the inner wall of the inner tube 204.

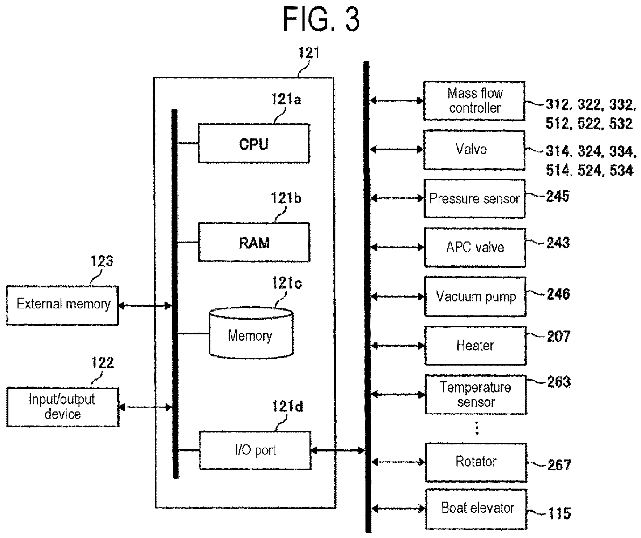

As shown in FIG. 3, the controller 121, which is a control part (control means), is constituted as a computer including a central processing unit (CPU) 121a, a random access memory (RAM) 121b, a memory 121c, and an I/O port 121d. The RAM 121b, the memory 121c, and the I/O port 121d are connected so as to be capable of exchanging data with the CPU 121a via an internal bus. An input/output device 122 constituted as, for example, a touch panel or the like is connected to the controller 121. The substrate processing apparatus may be configured to include one controller or multiple controllers. That is, a control to perform a processing sequence to be described later may be performed by using one controller or multiple controllers. The multiple controllers may be constituted as a control system connected to each other via a wired or wireless communication network, and the control to perform the processing sequence to be described later may be performed by the entire control system. When the term "controller" is used in the present disclosure, it may include one controller, multiple controllers, or a control system constituted by multiple controllers.

The memory 121c is constituted by, for example, a flash memory, a hard disk drive (HDD), or the like. The memory 121c readably stores a control program that controls an operation of the substrate processing apparatus, a process recipe in which procedures, conditions, and the like of the below-described method of manufacturing a semiconductor device (a method of processing a substrate) are described, and the like. The process recipe functions as a program that is combined to cause the controller 121 to execute each step (each step) in the below-described method of manufacturing the semiconductor device (the method of processing the substrate) to obtain a predetermined result. The process recipe functions as a program. Hereinafter, the process recipe, the control program, and the like are generally and simply referred to as a program. When the term "program" is used in the present disclosure, it may indicate a case of including the process recipe, a case of including the control program, or a case of including a combination of the process recipe and the control program. The RAM 121b is constituted as a memory area in which programs, data, and the like read by the CPU 121a are temporarily held.

The I/O port 121d is connected to the above-described MFCs 312, 322, 332, 512, 522, and 532, valves 314, 324, 334, 514, 524, 534, and 702, the pressure sensor 245, the APC valve 243, the vacuum pump 246, the heater 207, the temperature sensor 263, the rotator 267, the BE 115, and the like.

The CPU 121a is configured to read the control program from the memory 121c and execute the same. The CPU 121a is also configured to read the process recipe or the like from the memory 121c in response to an input of an operation command from the input/output device 122 or the like. The CPU 121a is configured to be capable of controlling flow rate regulating operations of various gases by the MFCs 312, 322, 332, 512, 522, and 532, opening/closing operations of the valves 314, 324, 334, 514, 524, 534, and 702, a gas storing operation in the storage 701 by the valve 702, an opening/closing operation of the APC valve 243, a pressure regulating operation by the APC valve 243 based on the pressure sensor 245, a temperature regulating operation of the heater 207 based on the temperature sensor 263, start and stop of vacuum pump 246, operations of rotating the boat 217 and adjusting a rotation speed of the boat 217 with the rotator 267, an operation of raising or lowering the boat 217 by the BE 115, an operation of accommodating the wafers 200 in the boat 217, and the like, according to the contents of the process recipe thus read.

The controller 121 may be constituted by installing, in a computer, the above-mentioned program stored in an external memory (e.g., a magnetic disk such as a hard disk or the like, an optical disc such as a CD or a DVD, and a semiconductor memory such as a USB memory or a memory card) 123. The memory 121c and the external memory 123 are constituted as a computer-readable recording medium. Hereinafter, these are generally and simply referred to as a recording medium. In the present disclosure, the recording medium may include the memory 121c, the external memory 123, or both of the memory 121c and the external memory 123. The program (program product) may be provided to the computer by using a communication means or unit such as the Internet or a dedicated line instead of using the external memory 123.

### (2) Substrate Processing Process

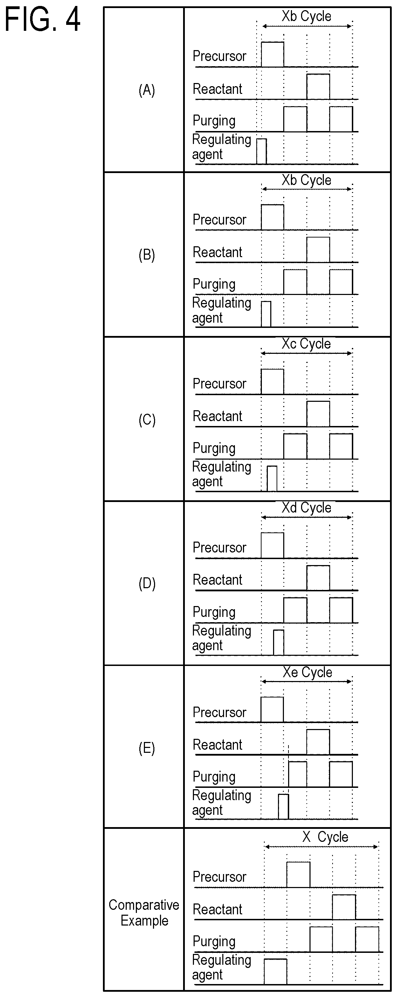

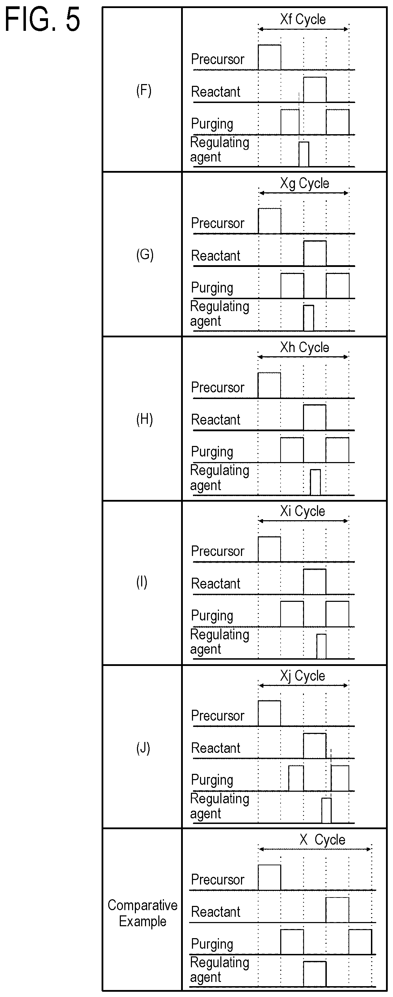

As a process of manufacturing a semiconductor device, an example of a process of forming a silicon nitride (SiN) film used as a charge trap film for a 3D NAND on a wafer 200 will be described with reference to FIGS. 4 and 5. The process of forming the SiN film is performed by using the process furnace 202 of the substrate processing apparatus 10 described above. In the embodiments of the present disclosure, an example will be described in which a substrate (wafer) with recesses such as trenches and holes formed on its surface is used as the wafer 200. In the following description, an operation of each component constituting the substrate processing apparatus 10 is configured to be controllable by the controller 121.

In a process of processing a substrate (a process of manufacturing a semiconductor device) according to the embodiments of the present disclosure, a film of elements contained in a precursor is formed on the wafer 200 by performing, a predetermined number of times:
(a) supplying the precursor to the wafer 200;
(b) supplying a reactant to the wafer 200;
(c) supplying a regulating agent, which regulates an amount of at least one selected from the group of a molecule of the precursor and a molecule of the reactant adsorbed on the wafer 200, to the wafer 200;
(d) performing a process in which at least one selected from the group of (a) and (b) overlaps (c); and
(e) after (d), performing (a) or (b) which overlaps (c) in (d) independently of (c).

In the embodiments of the present disclosure, the above-mentioned film formation sequence includes the sequences in (A) to (J) described below. The same notations as those set forth below are used in descriptions of other embodiments. (A) to (E) set forth below correspond to (A) to (E) of FIG. 4. (F) to (H) set forth below correspond to (F) to (H) of FIG. 5.
(A) (regulating agent → precursor + regulating agent → precursor → reactant) × Xa
(B) (regulating agent + precursor + regulating agent → reactant) × Xb
(C) (precursor → precursor + regulating agent → precursor → reactant) × Xc
(D) (precursor → precursor + regulating agent → reactant) × Xd
(E) (precursor → precursor + regulating agent → regulating agent → reactant) × Xe
(F) (precursor → regulating agent → reactant + regulating agent → reactant) × Xf
(G) (precursor → reactant + regulating agent → reactant) × Xg
(H) (precursor → reactant → reactant + regulating agent → reactant) × Xh
(I) (precursor → reactant + regulating agent → reactant) × Xi
(J) (precursor → reactant → reactant + regulating agent → regulating agent) × Xj.
Here, Xa to Xj are natural numbers (integers of 1 or 2 or more). "→" means supplying in order, and "+" means supplying simultaneously. Supplying simultaneously means that there is an overlapping supply period. The purging shown in FIGS. 4 and 5 is omitted in the above notation because it may not be performed.

When the term wafer" is used herein, it may refer to "a wafer itself" or "a stacked body of a wafer and a predetermined layer or film formed on a surface of the wafer." When the phrase "a surface of a wafer" is used herein, it may refer to "a surface of a wafer itself" or "a surface of a predetermined layer or film formed on a wafer." When the term "substrate" is used herein, it may be synonymous with the term "wafer."

### (Wafer Loading)

After a plurality of wafers 200 is charged to the boat 217, as shown in FIG. 1, the boat 217 supporting the plurality of wafers 200 is raised by the BE 115 and loaded into the process chamber 201. Thus, the boat 217 supporting the plurality of wafers 200 is accommodated in the process container. In this state, the SC 219 closes a lower end opening of the outer tube 203 via the O-ring 220.

### (Pressure Regulation and Temperature Regulation)

The inside of the process chamber 201, i.e., a space where the wafers 200 exist, is vacuum-exhausted by the vacuum pump 246 such that the internal pressure of the process chamber 201 reaches a desired pressure (a vacuum degree). At this time, the internal pressure of the process chamber 201 is measured by the pressure sensor 245. Then, the APC valve 243 is feedback-controlled based on the pressure information measured by the pressure sensor 245 (pressure regulation). The vacuum pump 246 is always kept in operation until at least the processing for the wafers 200 is completed. Further, the process chamber 201 is heated by the heater 207 such that an internal temperature of the process chamber 201 reaches a desired temperature. At this time, an amount of electric power supplied to the heater 207 is feedback-controlled based on the temperature information detected by the temperature sensor 263 so that a temperature distribution inside the process chamber 201 becomes a desired temperature distribution (temperature regulation). The inside of the process chamber 201 is continuously heated by the heater 207 at least until the processing on the wafers 200 is completed.

### (Regulating Agent Supply Step: First Step)

The controller 121 opens the valve 334 and allows the regulating agent to flow through the gas supply pipe 330. The regulating agent is supplied into the process chamber 201 from the gas supply holes 430a of the nozzle 430 after a flow rate of the regulating agent is regulated by the MFC 332. The regulating agent supplied into the process chamber 201 is exhausted via the exhaust pipe 231. At this time, the regulating agent is supplied to the wafer 200. Moreover, at this time, the controller 121 may open the valve 534 and may allow an inert gas such as an N₂ gas to flow through the gas supply pipe 530. The N₂ gas flowing through the gas supply pipe 530 is supplied into the process chamber 201 together with the regulating agent after a flow rate of the N₂ gas is regulated by the MFC 532. The N₂ gas supplied into the process chamber 201 is exhausted from the exhaust pipe 231. At this time, to prevent the regulating agent from entering the nozzles 410 and 420, the controller 121 may open the valves 512 and 524 to allow the N₂ gas to flow through the gas supply pipes 510 and 520. The N₂ gas is supplied into the process chamber 201 via the gas supply pipes 310 and 320 and the nozzles 410 and 420, and is exhausted via the exhaust pipe 231.

At this time, the controller 121 regulates the APC valve 243 to set the internal pressure of the process chamber 201 to, for example, 1,000 Pa, which is a pressure in a range of, for example, 1 to 3,990 Pa. A supply flow rate of the regulating agent controlled by the MFC 332 is, for example, a flow rate in a range of 0.005 to 5.0 slm. In this regard, the controller 121 regulates the internal pressure of the process chamber 201 and the supply flow rate and supply time of the regulating agent supplied into the process chamber 201 such that an exposure amount of the regulating agent to the wafer 200 becomes a first exposure amount. The first exposure amount in the present disclosure is obtained, for example, by product of a partial pressure of the regulating agent in the process chamber 201 and the supply time of the regulating agent supplied into the process chamber 201 (partial pressure × time). In addition, the first exposure amount is less than a second exposure amount described below. The supply flow rate of the N₂ gas controlled by the MFCs 512, 522, and 532 is set to, for example, a flow rate in a range of 0.1 to 5.0 slm, so as to suppress a gas containing a Group 15 element from entering each of the nozzles 410, 420, and 430. At this time, the temperature of the heater 207 is set to such a temperature that the temperature of the wafer 200 is, for example, in the range of 250 to 800 degrees C, specifically in the range of 600 to 700 degrees C. In addition, the expression of a numerical range such as "1 to 3 990 Pa" in the present disclosure means that a lower limit value and an upper limit value are included in that range. Therefore, for example, "1 to 3,990 Pa" means "1 Pa or more and 3,990 Pa or less." The same applies to other numerical ranges. The first exposure amount may be the product of the supply flow rate and supply time of the regulating agent supplied into the process chamber 201 (supply flow rate × supply time), the product of a total pressure in the process chamber 201 and the supply time of the regulating agent supplied into the process chamber 201 (total pressure × supply time), or the product of the partial pressure (total pressure) in the process chamber 201 and the supply flow rate and supply time of the regulating agent supplied into the process chamber 201 (partial pressure (total pressure) × supply flow rate × supply time). The supply flow rate of the regulating agent supplied into the process chamber 201 is affected by a volume of the process container, a pattern of a recess formed on the wafer 200, and the like. Therefore, the first exposure amount may be the product of the partial pressure in the process chamber 201 and the supply time of the regulating agent supplied into the process chamber 201.

Specifically, the exposure amount (first exposure amount or adsorption amount) of the regulating agent on the wafer 200 is an amount at which a molecule of the regulating agent is saturatedly adsorbed on the wafer 200. More specifically, the exposure amount (first exposure amount) of the regulating agent to the wafer 200 is an amount at which the molecule of the regulating agent is saturatedly adsorbed on an opening side (upper side) of the recess of the wafer 200 with the recess formed on its surface. In other words, specifically, the exposure amount of the regulating agent to the wafer 200 is an amount at which the adsorption of the molecule of the regulating agent on the wafer 200 is saturated. More preferably, the exposure amount of the regulating agent to the wafer 200 is an amount at which the adsorption of the molecule of the regulating agent on the opening side (upper side) of the recess of the wafer 200 with the recess formed on its surface is saturated.

In the present disclosure, the saturation means that adsorption sites of the wafer 200 may not be filled entirely but substantially saturated. In other words, to improve productivity, the adsorption may not completely saturated, in other words, the reaction may not be completely converged. In addition, in a combination of a gas species and a film species in which the characteristic of the reaction amount with respect to the gas supply time includes a saturation curve in a region larger than a certain supply time, the adsorption which is not completely saturated on the saturation curve may also be referred to as saturated adsorption in the present disclosure. In a case where the supply time is one on the saturation curve, at least one of effects of the present disclosure can be obtained. In a case where the supply time is set in a region of the supply time in which such a saturation curve is obtained, it may also be referred to as a supply for which a saturated adsorption characteristic is used.

The regulating agent supplied to the wafer 200 is, for example, a halogen element-containing agent. The halogen element-containing agent is a substance containing at least one or more of Group 17 elements. Such a substance includes, for example, hydrogen halide agents such as hydrogen fluoride (HF), hydrogen chloride (HCl), hydrogen bromide (HBr), and hydrogen iodide (HI). Furthermore, the regulating agent may also be a substance composed of halogen elements, for example, fluorine (F₂), chlorine (Cl₂), bromine (Br₂), and iodine (I₂). The regulating agent may also be a substance containing two types of halogen elements, such as nitrogen trifluoride (NF₃) and chlorine trifluoride (ClF₃). Specifically, a highly polarizable substance is used as the regulating agent. Such a highly polarizable substance is, for example, a hydrogen halide, specifically, HCl. A molecule of such a highly polarizable substance is easily adsorbed on the wafer 200. In addition, the highly polarizable substance can suppress adsorption of decomposition products (decomposition-generated products) generated by decomposition of the precursor, in addition to adsorption of the precursor itself described below. When the adsorption on the wafer 200 is not considered, a substance such as Cl₂ can be used as the regulating agent. This Cl₂ is smaller in polarity than hydrogen halide, but is larger in molecular size than the hydrogen halide. As the molecular size of Cl₂ is large, it exibits an effect of preventing adsorption of the molecule of the precursor and the decomposition product generated by the decomposition of the precursor. In other words, the adsorption inhibitor becomes a steric hindrance. The decomposition product of the precursor may be generated on the surface of the wafer 200 or in a space above the wafer 200.

By supplying such a regulating agent to the wafer 200, an adsorption inhibitor is formed on the surface of the wafer 200. The adsorption inhibitor is a molecule containing a halogen element, or the halogen element itself.

In addition, by exposing (supplying) the regulating agent to the wafer 200 at the first exposure amount, the molecule of the regulating agent or a portion of the molecule of the regulating agent can be adsorbed on the upper side of the recess formed on the surface of the wafer 200.

The regulating agent is not limited to an inorganic substance described above, and may be an organic regulating agent. The organic regulating agent is, for example, a substance containing an alkyl group (alkyl ligand). The alkyl group is, for example, a methyl group. The methyl group is electrically negative and repels a negative molecule of the precursor. Therefore, the methyl group is difficult to bond with the molecule of the precursor. For example, the methyl group (Me-) and the halogen (Cl-) contained in the molecule of the precursor are both negative, making it difficult for them to bond with each other. In this case, Me means methyl. That is, by previously adsorbing a substance containing an alkyl group to a specific location on the wafer 200, it is possible to suppress the subsequently supplied precursor from being adsorbed on the specific location on the wafer 200. In addition, examples of the substance containing an alkyl group include hexamethyldisilazane, dimethylaminotrimethylsilane, trimethylsilanol, and triethylsilanol.

After a predetermined time, for example, 1 to 600 seconds, elapses since start of the supply of the regulating agent, the controller 121 closes the valve 334 of the gas supply pipe 330 to stop the supply of the regulating agent. At this time, the controller 121 leaves the APC valve 243 of the exhaust pipe 231 open and causes the vacuum pump 246 to vacuum-exhaust the process chamber 201, thereby removing the regulating agent unreacted or contributed to formation of the adsorption inhibitor, which remains in the process chamber 201, from the inside of the process chamber 201.

As shown in FIGS. 4 and 5, timing to perform the first step is appropriately adjusted.

### (Precursor Supply Step: Second Step)

The controller 121 opens the valve 314 and allows the precursor to flow through the gas supply pipe 310. The precursor is supplied into the process chamber 201 from the gas supply holes 410a of the nozzle 410 after the flow rate of the precursor is regulated by the MFC 312. The precursor supplied into the process chamber 201 is exhausted via the exhaust pipe 231. In this way, the precursor is supplied to the wafer 200. At this time, the controller 121 opens the valve 514 and allows an inert gas such as a N₂ gas to flow through the gas supply pipe 510. The N₂ gas flowing through the gas supply pipe 510 is supplied into the process chamber 201 together with the precursor after a flow rate of the N₂ gas is regulated by the MFC 512. The N₂ gas supplied into the process chamber 201 is exhausted via the exhaust pipe 231. At this time, to prevent the precursor from entering the nozzles 420 and 430, the controller 121 may open the valves 524 and 534 to allow the N₂ gas to flow through the gas supply pipes 520 and 530. The N₂ gas is supplied into the process chamber 201 via the gas supply pipes 320 and 330 and the nozzles 420 and 430, and is then exhausted via the exhaust pipe 231.

At this time, the controller 121 regulates the APC valve 243 to set the internal pressure of the process chamber 201 to, for example, 500 Pa in a range of, for example, 1 to 3,990 Pa. The supply flow rate of the precursor controlled by the MFC 312 is, for example, 1 to 2,000 sccm, specifically 10 to 1,000 sccm. Here, precursor supply conditions are set so that the exposure amount of the precursor to the wafer 200 is a second exposure amount greater than the first exposure amount. The second exposure amount in the present disclosure is, for example, the product of the partial pressure of the precursor in the process chamber 201 and the supply time of the precursor supplied into the process chamber 201 (partial pressure × time). The supply flow rate of the N₂ gas controlled by the MFCs 512, 522, and 532 is, for example, within a range of 0.1 to 5.0 slm. At this time, the temperature of the heater 207 is set to such a temperature that the temperature of the wafer 200 is, for example, within a range of 250 to 800 degrees C, specifically 600 to 700 degrees C. In addition, the second exposure amount in the present disclosure may also be the product of the supply flow rate and supply time of the precursor supplied into the process chamber 201 (supply flow rate × supply time), the product of the total pressure in the process chamber 201 and the supply time of the precursor supplied into the process chamber 201 (total pressure × supply time), or the product of the partial pressure (total pressure) in the process chamber 201 and the supply flow rate and supply time of the precursor supplied into the process chamber 201 (partial pressure (total pressure) × supply flow rate × supply time). The supply flow rate of the precursor supplied into the process chamber 201 is affected by the volume of the process container, the pattern of the recess formed on the wafer 200, and the like. Therefore, the second exposure amount may be the product of the partial pressure in the process chamber 201 and the supply time of the precursor supplied into the process chamber 201.

Further, the amount of the gas exposed to the wafer 200 in the present disclosure may also be expressed as an amount of the molecule of the gas adsorbed on the surface of the wafer 200. As described above, this amount of adsorption can be regulated by, for example, the product of the partial pressure of the gas (the regulating agent or precursor) in the process chamber 201 and the supply time of the gas (the regulating agent or precursor) supplied into the process chamber 201 (partial pressure × time).

In the present disclosure, the second exposure amount (adsorption amount) may be made greater than the first exposure amount (adsorption amount) by regulating at least one selected from the group of the partial pressure, total pressure, supply flow rate, and supply time related to the second exposure amount to be greater than at least one selected from the group of the partial pressure, total pressure, supply flow rate, and time related to the first exposure amount.

The second exposure amount (adsorption amount) of the precursor may be an amount at which the adsorption of the molecule of the precursor on the wafer 200 is not saturated, as in a graph shown in FIG. 7. In other words, the second exposure amount (adsorption amount) of the precursor may be an amount at which the molecule of the precursor is not saturatedly adsorbed on the wafer 200.

The precursor may be stored in the storage 701 and may be supplied from the storage 701 to the process chamber 201. In a case where the precursor stored in the storage 701 is supplied into the process chamber 201, the supply time of the precursor supplied into the process chamber 201 may be shorter than the supply time of the regulating agent supplied into the process chamber 201. In this case, for example, the exposure amounts (first exposure amount and second exposure amount) of the precursor and the regulating agent are regulated so that the product of the partial pressure (total pressure) of the precursor in the process chamber 201 and the supply time of the precursor supplied into the process chamber 201 is greater than the product of the partial pressure (total pressure) of the regulating agent in the process chamber 201 and the supply time of the regulating agent supplied to the process chamber 201. In the precursor supply step (third step), the precursor may be supplied into the process chamber 201 multiple times as well as one time. In a case where the precursor is supplied into the process chamber 201 multiple times, the supply of the precursor into the process chamber 201 is stopped between a predetermined time and the next time. In addition, in a case where the precursor is supplied into the process chamber 201 multiple times, the precursor stored in the storage 701 may be supplied into the process chamber 201 at least once. For example, in a case where the precursor is supplied into the process chamber 201 two or more times, the precursor stored in the storage 701 is supplied into the process chamber 201 at the first time, and the precursor is supplied into the process chamber 201 without being stored in the storage 701 at the second time. The supply of the precursor into the process chamber 201 is stopped between the first time and the second time. In addition, the inside of the process chamber 201 may be exhausted (depressurized) in accordance with the stop of the supply of the precursor into the process chamber 201, or an inert gas may be supplied into the process chamber 201 in accordance with the exhaust. The supply and stop of the precursor into the process chamber 201 are controlled, for example, by opening or closing the valve 702.

The precursor supplied to the wafer 200 contains, for example, a main element constituting a film formed on the wafer 200. The main element is, for example, Si. For example, a silane-based gas containing Si may be used as the precursor. For example, a gas containing Si and a halogen, i.e., a halosilane gas may be used as the silane-based gas. The halogen includes chlorine (Cl), fluorine (F), bromine (Br), iodine (I), etc. For example, a chlorosilane gas containing Si and Cl may be used as the halosilane gas.

The precursor may be, for example, a chlorosilane gas such as a monochlorosilane (SiH₃Cl) gas, a dichlorosilane (SiH₂Cl₂) gas, a trichlorosilane (SiHCl₃) gas, a tetrachlorosilane (SiCl₄) gas, a hexachlorodisilane gas (Si₂Cl₆, abbreviated as HCDS), an octachlorotrisilane (Si₃Cl₈) gas or the like. As the precursor, one or more of these gases may be used.

The precursor may be the chlorosilane gas and, for example, a fluorosilane gas such as a tetrafluorosilane (SiF₄) gas, a difluorosilane (SiH₂F₂) gas or the like, a bromosilane gas such as a tetrabromosilane (SiBr₄) gas, a dibromosilane (SiH₂Br₂) gas or the like, or an iodosilane gas such as a tetraiodosilane (SiI₄) gas, a diiodosilane (SiH₂I₂) gas or the like. One or more of these gases may be used as the precursor.

The precursor may be these gases and, for example, a gas containing Si and an amino group, i.e., an aminosilane gas. The amino group is a monovalent functional group obtained by removing hydrogen (H) from ammonia, primary amine, or secondary amine, and can be represented as -NH₂, -NHR, or -NR₂. The R represents an alkyl group, and the two R's in -NR₂ may be the same or different.

The precursor may be, for example, an aminosilane gas such as a tetrakis(dimethylamino)silane (Si[N(CH₃)₂]₄) gas, a tris(dimethylamino)silane (Si[N(CH₃)₂]₃H) gas, a bis(diethylamino)silane (Si[N(C₂H₅)₂]₂H₂) gas, a bis(tertiary-butylamino)silane (SiH₂[NH(C₄H₉)]₂) gas, and a (diisopropylamino)silane (SiH₃[N(C₃H₇)₂]). As the precursor, one or more of these gases may be used.

In the present disclosure, an example in which a HCDS gas is used as the precursor is described. In a case where the HCDS gas is used as the precursor, a silicon (Si)-containing layer containing chlorine (Cl) with a predetermined thickness may be formed as a first layer on the outermost surface of the wafer 200. The Si-containing layer containing Cl may be formed by physical adsorption or chemical adsorption of the molecule of the precursor, physical adsorption or chemical adsorption of a molecule of a substance (also referred to as a decomposition-generated product) obtained by decomposing at least a part of the molecule of the precursor, or deposition of Si obtained by thermal decomposition of the precursor, on the outermost surface of the wafer 200. In the present disclosure, the decomposition-generated product is also referred to as a ligand of the precursor or a part of the ligand of the precursor. The decomposition-generated product in a case where HCDS is used as the precursor is, for example, SiClₓ where x is 2, 3, or 4. The Si-containing layer containing Cl may be an adsorption layer (physical adsorption layer or chemical adsorption layer) of a molecule of a chlorosilane gas or a molecule of a substance obtained by decomposing a part of the chlorosilane gas, or may be a deposition layer of Si containing Cl. In a case where the above-mentioned chemical adsorption layer or the above-mentioned deposition layer is formed on the outermost surface of the wafer 200, Si contained in the chlorosilane gas is adsorbed on the outermost surface of the wafer 200. In the present disclosure, the Si-containing layer containing Cl is also simply referred to as a Si-containing layer.

In addition, before the supply of the HCDS gas, the regulating agent is supplied, and an adsorption inhibitor may be formed on the surface of the wafer 200 by the regulating agent. For example, this is the case of sequence (A) of FIG. 4. When a HCl gas is used as the regulating agent, an adsorption inhibitor such as HCl or Cl, which is a part of HCl, is formed on the surface of the wafer 200. Such an adsorption inhibitor suppresses the adsorption of the molecule of the HCDS gas and the adsorption of SiClₓ. In other words, presence of the adsorption inhibitor can suppress adsorption of a part of the ligand of the precursor. Depending on a structure of the molecule (atom) constituting the adsorption inhibitor, it is possible to suppress adsorption of SiClₓ with a specific number of x among the SiClₓ.

A supply period (also referred to as a timing) of the precursor and a supply period of the regulating agent may be set as shown in (A), (B), (C), (D), and (E) of FIG. 4. In the present disclosure, the "supply period" refers to a time from start to stop of supplying the precursor (the regulating agent or the reactant described later).

As shown in (A), (B), (C), (D), and (E) of FIG. 4, there is a period during which the supply of the precursor and the supply of the regulating agent overlap each other. In other words, there is a period during which the precursor and the regulating agent are supplied to the wafer 200 at the same time.

Furthermore, as shown in (C), (D), and (E) of FIG. 4, the supply of the regulating agent may be started after the supply of the precursor is started.

Moreover, as shown in (A), (B), and (C) of FIG. 4, there may be a period in which the precursor is supplied after the supply of the regulating agent is stopped.

In addition, as shown in (A) of FIG. 4, there may be a period in which the regulating agent is supplied independently before the supply of the precursor is started.

In addition, as shown in (E) of FIG. 4, there may be a period in which the regulating agent is supplied independently after the supply of the precursor is stopped. This is also referred to as continuing the supply of regulating agent after the supply of the precursor is stopped.

### (Residual Gas Removal)

After a predetermined time, for example, 1 to 60 seconds, elapses since the start of the supply of the precursor, the controller 121 closes the valve 314 of the gas supply pipe 310 to stop the supply of the precursor. In other words, the time for supplying the precursor to the wafer 200 is set to, for example, a time within the range of 1 to 60 seconds. At this time, the controller 121 leaves the APC valve 243 of the exhaust pipe 231 open and causes the vacuum pump 246 to vacuum-exhaust the inside of the process chamber 201, such that the precursor unreacted or contributed to the formation of the layer, which remains in the process chamber 201, is removed from the inside of the process chamber 201. In other words, the controller 121 exhausts the atmosphere in the process chamber 201. At this time, the controller 121 may leave the valves 514, 524, and 534 open and maintain supplying the N₂ gas into the process chamber 201. The N₂ gas acts as a gas that suppresses a gas from entering each of nozzles 410, 420, and 430, and also acts as a purge gas. In the case where the N₂ gas is supplied as the purge gas, it is possible to enhance an effect of removing the precursor unreacted or contributed to the formation of the layer, which remains in the process chamber 201, from the inside of the process chamber 201.

### (Reactant Supply: Third Step)

After removing the residual gas from the process chamber 201, the controller 121 opens the valve 324 and allows the reactant to flow through the gas supply pipe 320. The reactant is supplied into the process chamber 201 from the gas supply holes 420a of the nozzle 420 after a flow rate of the reactant is regulated by the MFC 322. The reactant supplied into the process chamber 201 is exhausted from the exhaust pipe 231. At this time, the reactant is supplied to the wafer 200. Furthermore, at this time, the controller 121 maintains the supply of the N₂ gas into the gas supply pipes 510, 520, and 530 by keeping the valves 514, 524, and 534 open. The flow rate of the N₂ gas flowing through the gas supply pipes 510, 520, and 530 is regulated by the MFCs 512, 522, and 532, respectively. The N₂ gas flowing through the gas supply pipe 520 is supplied together with the reactant into the process chamber 201 via the gas supply pipe 320 and the nozzle 420, and then exhausted via the exhaust pipe 231. The N₂ gas flowing through the gas supply pipe 530 is supplied into the process chamber 201 via the gas supply pipe 330 and the nozzle 430, and then exhausted via the exhaust pipe 231. The N₂ gas flowing through the gas supply pipe 510 is supplied into the process chamber 201 via the gas supply pipe 310 and the nozzle 410, and then exhausted via the exhaust pipe 231. This suppresses the reactant from entering the nozzle 410.

At this time, the controller 121 regulates the APC valve 243 to set the internal pressure of the process chamber 201 to, for example, 5,000 Pa within a range of, for example, 1 to 13,300 Pa. The supply flow rate of the reactant controlled by the MFC 322 is set to a flow rate within a range of, for example, 1 to 50 slm, specifically 15 to 40 slm. Each of the supply flow rates of the N₂ gas controlled by the MFCs 512, 522, and 532 is set to a flow rate within a range of, for example, 0.1 to 5.0 slm.

The exposure amount (adsorption amount) of the reactant to the wafer 200 may be set to an amount at which the adsorption of the molecule of the reactant on the wafer 200 is saturated. In other words, the exposure amount (adsorption amount) of the reactant to the wafer 200 may be set to an amount at which the molecule of the reactant is saturatedly adsorbed on the wafer 200.

The reactant supplied to the wafer 200 may be, for example, a nitrogen (N)- and hydrogen (H)-containing gas, which is a nitriding gas (nitriding agent). The N- and H-containing gas may be both an N-containing gas and a H-containing gas. The N- and H-containing gas may contain N-H bonds.

The reactant may be, for example, a hydrogen nitride gas such as an ammonia (NH₃) gas, a diazene (N₂H₂) gas, a hydrazine (N₂H₄) gas, or a N₃H₈ gas. One or more of these gases may be used as the reactant. When the reactant contains hydrogen, the reactant may be referred to as a reducing agent. In a case where the reducing agent is a gas, it may be referred to as a reducing gas.

The reactant may be these gases and a nitrogen (N)-, carbon (C)-, and hydrogen (H)-containing gas. As the N-, C-, and H-containing gas, for example, an amine-based gas or an organic hydrazine-based gas may be used. The N-, C-, and H-containing gas may be a N-containing gas, a C-containing gas, a H-containing gas, or a N- and C-containing gas.

The reactant may be, for example, an ethylamine-based gas such as a monoethylamine (C₂H₅NH₂) gas, a diethylamine ((C₂H₅)₂NH) gas, a triethylamine ((C₂H₅)₃N) gas or the like, a methylamine-based gas such as a monomethylamine (CH₃NH₂) gas, a dimethylamine ((CH₃)₂NH) gas, a trimethylamine ((CH₃)₃N) gas or the like, or an organic hydrazine-based gas such as a monomethylhydrazine ((CH₃)HN₂H₂) gas, a dimethylhydrazine ((CH₃)₂N₂H₂) gas, a trimethylhydrazine ((CH₃)₂N₂(CH₃)H) gas or the like, etc. As the reactant, one or more of these gases may be used. These gases are also referred to as amine-based gases.

As shown in FIG. 5, the regulating agent may be provided in the vicinity of the period during which the reactant is supplied.

For example, as shown in (F), (G), (H), (I), and (J) of FIG. 5, a sequence may be configured to include a period in which the supply of the reactant and the supply of the regulating agent overlap each other, in other word, a period in which the reactant and the regulating agent are supplied to the wafer 200 simultaneously.

Furthermore, as shown in (F) of FIG. 5, the regulating agent may be supplied independently before the supply of the reactant.

Moreover, as shown in (I) and (J) of FIG. 5, the supply of the regulating agent may be started after the supply of the reactant is started.

In addition, as shown in (J) of FIG. 5, the regulating agent may be supplied independently after the supply of the reactant is stopped. This is also referred to as continuing the supply of the regulating agent after the supply of the reactant is stopped.

### (Residual Gas Removal)

After a predetermined time, for example 1 to 1,200 seconds, elapses since the start of the supply of the reactant, the controller 121 closes the valve 324 of the gas supply pipe 320 to stop the supply of the reactant. Then, by the same processing procedure as that of the second step described above, the reactant unreacted or contributed to the formation of the layer and the reaction by-products, which remain in the process chamber 201, are removed from the inside of the process chamber 201. In other words, the controller 121 exhausts the atmosphere in the process chamber 201.

### (Performing a Predetermined Number of Times)

A film of the element contained in the precursor is formed with a predetermined thickness on the wafer 200 by performing a cycle at least once (a predetermined number of times (n times where n is an integer of 1 or 2 or more)), the cycle including the first step, the second step, and the third step performed sequentially. For example, a SiN film may be formed on the wafer 200. The above-described cycle may be performed a plurality of times.

### (Purging and Returning to Atmospheric Pressure)

The controller 121 supplies a N₂ gas from each of the gas supply pipes 510, 520, and 530 into the process chamber 201. The N₂ gas supplied into the process chamber 201 is exhausted via the exhaust pipe 231. The N₂ gas acts as a purge gas. This causes the process chamber 201 to be purged with the inert gas, and the gas or the reaction by-products remaining in the process chamber 201 are removed from the inside of the process chamber 201. The atmosphere in the process chamber 201 is then replaced with the inert gas, and the internal pressure of the process chamber 201 is returned to an atmospheric pressure.

### (Wafer Unloading)

Thereafter, the SC 219 is lowered by the BE 115, and the lower end of the outer tube 203 is opened. Then, the processed wafers 200 supported by the boat 217 are unloaded from the lower end of the outer tube 203 to the outside of the outer tube 203. The processed wafers 200 are then discharged from the boat 217.

### (3) Effect of the Embodiments

The embodiments of the present disclosure may provide one or more of the following effects.
(a) By supplying the regulating agent to the wafer 200, it is possible to suppress adsorption of a large amount of precursor on a specific location of the wafer 200. Therefore, it is possible to suppress a film thickness of the specific location of the wafer 200 from becoming large, and to increase film thicknesses of other locations. In addition, it is possible to enable the molecule of the precursor adsorbed on the specific location of the wafer 200 to reach other locations. In other words, it is possible to reduce consumption of the precursor at the specific location of the wafer 200 and to increase consumption of the precursor at other locations of the wafer 200. In this case, the specific location includes, for example, the following locations. The specific location may be a location close to the nozzle of the wafer 200, or an upper portion of a recess in a case where the recess is formed in the wafer 200. When the specific location is the location close to the nozzle of the wafer 200, it is possible to improve an in-plane film thickness uniformity of the wafer 200 as a film characteristic. When the specific location is the upper portion of the recess, it is possible to reduce the adsorption (consumption) amount of the precursor at the upper portion of the recess and to increase the adsorption (consumption) amount of the precursor at the bottom of the recess. This makes it possible to improve a film thickness uniformity in a depth direction of the recess of the film formed on the wall and bottom of the recess. In other words, it is possible to improve a step coverage as a film characteristic. In this case, the recess refers to a trench or a hole. In addition, the hole may include a blind hole and a through-hole.
(b) Even in a case where a gas that decomposes in a gas phase is used as the precursor, it is possible to improve uniformity of the film formed on the wafer 200, particularly the step coverage of the recess. The gas that decomposes in the gas phase is, for example, a chlorosilane-based gas, specifically, a HCDS gas. When the HCDS is used, the decomposition of the HCDS produces, for example, SiCl₂ and SiCl₄ as decomposition-generated products. Of these, SiCl₂ causes a CVD reaction to occur. Due to the occurrence of the CVD reaction, a relationship between a supply time of the precursor supplied to the wafer 200 and an increase in the film thickness of the wafer 200 (film thickness per cycle) does not become a saturated relationship. That is, an unsaturated characteristic is obtained. The unsaturated characteristic means that the film thickness of the wafer 200 (film thickness per cycle) does not converge to a predetermined value even in a case where the supply time of the precursor supplied to the wafer 200 increases. In a case where a film is formed on the wafer 200 under a condition where this unsaturated characteristic is obtained, a film thickness of a specific portion of the wafer 200 increases, such that film thickness uniformity of the wafer 200 may deteriorate. For a film formed in a recess, a step coverage may deteriorate. According to the technique disclosed herein, by supplying the regulating agent to the wafer 200, it is possible to suppress an intermediate that causes the unsaturated characteristic, such as SiCl₂, from being adsorbed on the wafer 200. As a result, it is possible to improve the film thickness uniformity of the wafer 200. In addition, in the case where the wafer 200 including the recess is processed, it is possible to improve the step coverage of the film formed in the recess. Among such decomposition products, an amount of SiCl₂ generated is proportional to the supply time of the HCDS gas supplied to the wafer 200. That is, as the supply time of the HCDS gas supplied to the wafer 200 increases, the amount of SiCl₂ generated increases. The increase in the amount of SiCl₂ generated is caused by the fact that a residence time of molecules of HCDS in the process chamber 201 increases as the supply time of HCDS supplied to the wafer 200 increases. That is, it is considered that as the residence time of the molecules of HCDS in the process chamber 201 increases, a time during which the molecules of HCDS are heated in the process chamber 201 increases, thus increasing the number of molecules that are thermally decomposed. To reduce the amount of SiCl₂ generated and the amount of SiCl₂ adsorbed on the wafer 200, the supply time of the HCDS gas supplied to the wafer 200 may be reduced. To reduce the supply time of the HCDS gas supplied to the wafer 200, the storage 701 may be used to instantaneously supply (also referred to as a flush supply) the HCDS gas to the wafer 200.
(c) By using an inorganic regulating agent (e.g., a gas containing a halogen element) as the regulating agent, it is possible to reduce an increase in an amount of impurities generated by the regulating agent in the film formed on the wafer 200. In this case, the impurities are elements other than the main element constituting the film formed on the wafer 200. On the other hand, a molecular size of an organic regulating agent is larger than that of the inorganic regulating agent. Therefore, in a case where the organic regulating agent is used as the regulating agent, an effect of the regulating agent acting as a steric hindrance that inhibits the adsorption of the precursor on the wafer 200 is greater than in a case where the inorganic regulating agent is used as the regulating agent.
(d) As shown in (A), (B), (C), (D), and (E) of FIG. 4, there is a period in which the supply of the precursor and the supply of the regulating agent overlap each other. During such a period, the regulating agent can suppress the molecule of the precursor present in a space above the wafer 200 from being adsorbed on the wafer 200. Furthermore, adsorption of the molecule of the precursor that is not completely adsorbed on the wafer 200 can be suppressed. This makes it possible to regulate an adsorption amount of the molecule of the precursor adsorbed on the wafer 200. Further, it is possible to suppress the molecule of the precursor from being multiple-adsorbed on the wafer 200. In this case, the multiple adsorption means that multiple molecules of the precursor are adsorbed on a specific location of the wafer 200.
(e) As shown in (C), (D), and (E) of FIG. 4, by starting the supply of the regulating agent after starting the supply of the precursor, in addition to the effect of (d), it is possible to suppress the intermediate of the precursor generated after starting the supply of the precursor from being adsorbed on the wafer 200. The adsorption of the intermediate of the precursor on the wafer 200 is inhibited by the regulating agent.
(f) As shown in (A), (B), and (C) of FIG. 4, by providing the period in which the precursor is supplied after the supply of the regulating agent is stopped, it is possible to increase the adsorption amount of the precursor adsorbed on portions of the wafer 200 where the regulating agent is not adsorbed.
(g) As shown in (A) of FIG. 4, by providing a period in which the regulating agent is supplied independently before the supply of the precursor is started, it is possible to form a layer obtained by the molecule of the regulating agent adsorbed on the surface of the wafer 200. By forming this layer, it is possible to reduce the adsorption amount of the molecule of the precursor adsorbed on the wafer 200.
(h) As shown in (E) of FIG. 4, by providing a period in which the regulating agent is supplied after the supply of the precursor is stopped, it is possible to suppress the molecule of the precursor present in the space above the wafer 200 from being adsorbed on the wafer. Further, it is possible to suppress the adsorption of the molecule of the precursor that is not completely adsorbed on the wafer 200. The supply of the regulating agent after the supply of the precursor in sequence (E) is also referred to as removing (purging) the precursor.
(i) In a sequence of a comparative example shown in Fig. 4, the regulating agent adsorbed on the wafer 200 exhibits the effect of suppressing the adsorption of the molecule of the precursor on the wafer 200. In the sequences (A), (B), (C), (D), and (E), in addition to the effect of the comparative example, the above-described effects can be obtained and the time for the cycle of each sequence can be shortened. That is, in the sequences (A), (B), (C), (D), and (E), the processing time of the wafer 200 can be shortened compared to the comparative example. That is, it is possible to improve a manufacturing throughput of the semiconductor device.
(j) As shown in (F), (G), (H), (I), and (J) of FIG. 5, by providing a period in which the supply of the reactant and the supply of the regulating agent overlap each other, it is possible for the regulating agent to suppress the molecule of the reactant present in the space above the wafer 200 from being adsorbed on the wafer 200. Further, adsorption of the molecule of the reactant that is not completely adsorbed on the wafer 200 can be suppressed. Further, the molecules of the reactant adsorbed on the wafer 200 or a part of the molecules thereof can be desorbed. In addition, it is possible to suppress the multiple adsorption of the molecules of the reactant or a part of the molecules thereof on the wafer 200.
(k) As shown in (F) of FIG. 5, by supplying the regulating agent before supplying the reactant, it is possible to suppress the reactant from being adsorbed on the wafer 200. In addition, it is possible to suppress multiple adsorption of the molecules of the reactant or a part of the molecules thereof on the wafer 200.
(l) As shown in (I) and (J) of FIG. 5, by starting the supply of the regulating agent after the supply of the reactant is started, the molecules of the reactant can be removed by the regulating agent from a surface side of the molecules of the reactant multiple-adsorbed on the wafer 200. In a case where the precursor is a material containing Si, the reactant is an agent containing nitrogen and hydrogen, and the regulating agent is an agent containing halogen, it is possible to reduce at least an amount of nitrogen from the surface of the wafer 200, and to suppress a decrease in refractive index of the film formed on the wafer 200.
(m) As shown in (J) of FIG. 5, by supplying the regulating agent after the supply of the reactant is stopped, the amount of the reactant present in the space above the wafer 200 becomes small, which makes it easy to reduce the number of the molecules of the reactant adsorbed on the wafer 200. It is possible to suppress the reactant desorbed from the wafer 200 from being readsorbed on the wafer 200. This is because the reactant can be exhausted before being readsorbed on the wafer 200. During the period in which the regulating agent is supplied independently, the supply of the regulating agent is also referred to as removing (purging) the reactant.
(n) In a sequence of a comparative example shown in FIG. 5, the regulating agent supplied to the wafer 200 exhibits an effect of suppressing the adsorption of the molecule of the reactant on the wafer 200. In the sequences (F), (G), (H), (I), and (J), in addition to the effect of the comparative example, the above-described effects can be obtained and the time for the cycle of each sequence can be shortened. That is, in the sequences (F), (G), (H), (I), and (J), the processing time of the wafer 200 can be shortened compared to the comparative example. That is, it is possible to improve the manufacturing throughput of the semiconductor device. In the comparative example of FIG. 5, there is shown the example in which the regulating agent is supplied before the reactant is supplied. However, the present disclosure is not limited thereto. For example, it may be configured to supply the regulating agent after the reactant is supplied.
(o) As shown in (A), (B), (C), (D), and (E) of FIG. 4, there are a period in which the supply of the precursor and the supply of the regulating agent are partially overlapped, and a period in which the respective supplies are performed independently. This makes it possible to obtain both the effect obtained by performing the respective supplies independently and the effect obtained by performing the respective supplies in the overlapping manner. In addition, compared to the comparative example, it becomes easier to control the amount of the precursor adsorbed on the wafer 200.
(p) As shown in (F), (G), (H), (I), and (J) of FIG. 5, there are a period in which the supply of the reactant and the supply of the regulating agent are partially overlapped, and a period in which the respective supplies are performed independently. This makes it possible to obtain both the effect obtained by performing the respective supplies independently and the effect obtained by performing the respective supplies in the overlapping manner. In addition, it becomes easier to control the amount of the reactant adsorbed on the wafer 200 compared to the comparative example.

As in the above-mentioned effects, the regulating agent suppresses the molecule of the precursor from being adsorbed on the wafer 200 and promotes the desorption of the reactant from the wafer 200. In other words, the regulating agent modifies a surface state of the wafer 200. Therefore, the regulating agent used herein is also referred to as a post-processing gas, a post-treatment gas, a treatment gas, a modifying gas, or a desorption promoting gas. In addition, the regulating agent used when supplying the precursor of the present disclosure may also be referred to as a pre-processing gas, a pre-treatment gas, a treatment gas, or a modifying gas, because it can change the surface state (surface characteristic, or adsorption characteristic) of the wafer 200.

### <Other Embodiment of the Present Disclosure>

The embodiments of the present disclosure are described above in detail. However, the present disclosure is not limited to the above-described embodiments, and various modifications may be made without departing from the spirit of the present disclosure.

For example, in the above-described embodiments, examples where the gas containing a Si element is used as the precursor are described. However, the present disclosure is not limited thereto. For example, the present disclosure may be applicable to a process in which a gas containing at least one selected from the group of a Group 13 element, a Group 14 element, a Group 4 element, a Group 6 element, and a Group 8 element is used as the precursor.

In the above-described embodiments, the cases where the gas containing a nitrogen element is used as the reactant are described. However, the present disclosure is not limited thereto. For example, a gas containing an oxygen element may be used as the reactant to form an oxide film on the wafer 200. Examples of the gas containing oxygen include an oxygen (O₂) gas, water (H₂O), a hydrogen peroxide (H₂O₂) gas, a nitrous oxide (dinitrogen monoxide) (N₂O) gas, a nitric oxide (NO) gas, and an ozone (O3) gas. In addition, a gas obtained by activating or exciting one or more of these gases may be used as the reactant.

Further, a gas containing a hydrogen element may be used as the reactant to form a film mainly containing the element on the wafer 200. Examples of the gas containing the hydrogen element include a gas constituted by a hydrogen element, such as a hydrogen (H₂) gas, a deuterium gas or the like, and a mononuclear parent hydride gas such as a silane-based gas, a borane-based gas, a phosphane-based gas, a germane-based gas or the like. Further, a gas obtained by activating or exciting one or more of these gases may be used as the reactant. The silane-based gas may be a monosilane (SiH₄) gas, a disilane (Si₂H₆) gas, a trisilane (Si₃H₈) gas or the like. The borane-based gas may be a monoborane (BH₃) gas, a diborane (B₂H₆) gas or the like. The phosphane-based gas may be a phosphine (PH₃) gas, a diphosphine (P₂H₆) gas or the like. The germane-based gas may be a monogermane (GeH₄) gas, a digermane (Ge₂H₆) gas, a trigermane (Ge₃H₈) gas or the like.

In the above-described embodiments, there the examples are described in which film formation is performed by using a batch-type vertical substrate processing apparatus configured to process a plurality of substrates at a time. However, the present disclosure is not limited thereto, and may be suitably applied to, for example, a case where film formation is performed by using a single-substrate type substrate processing apparatus configured to process one or several substrates at a time. Further, in the above-described embodiments, the examples are described in which the film is formed by using the substrate processing apparatus including a hot-wall-type process furnace. The present disclosure is not limited to the embodiment described above, and may be suitably applied to a case where a film is formed by using a substrate processing apparatus including a cold-wall-type process furnace. When using these substrate processing apparatuses, film formation can be performed under the same sequences and processing conditions as in the above-described embodiments.

In the above-described embodiments, the examples are described in which the above-mentioned processing sequence is performed in the same process chamber of the same processing apparatus (in-situ). The present disclosure is not limited to the above-described embodiments. For example, one step and another step of the above-mentioned processing sequence may be performed in different process chambers of different processing apparatuses (ex-situ), or may be performed respectively in different process chambers of the same processing apparatus.

The process recipes (the programs that describe processing procedures, processing conditions, etc.) used when forming various thin films may be provided individually (in a multiple number) according to contents of the substrate processing process (film type, composition ratio, film quality, film thickness, processing procedure, processing condition or the like of the thin film to be formed). When starting the substrate processing process, an appropriate process recipe may be selected from a plurality of process recipes according to the contents of the substrate processing process. Specifically, the plurality of process recipes individually provided according to the contents of the substrate processing process may be stored (installed) in the memory 121c of the substrate processing apparatus in advance via a telecommunication line or a recording medium (external memory 123) in which the process recipe is recorded. Specifically, when starting the substrate processing process, the CPU 121a of the substrate processing apparatus may properly select an appropriate process recipe from the plurality of process recipes stored in the memory 121c according to the contents of the substrate processing process. According to this configuration, it is possible for a single substrate processing apparatus to form thin films of various film types, composition ratios, film qualities, and film thicknesses in a versatile and reproducible manner. In addition, it is possible to alleviate an operator's operation burden (burden in inputting processing procedures, processing conditions, etc.) and to quickly start the substrate processing process while avoiding operation errors of the operator.

Further, the present disclosure can also be realized by, for example, changing process recipes of an existing substrate processing apparatus. In a case where the process recipes are changed, the process recipes according to the present disclosure may be installed on an existing substrate processing apparatus via a telecommunications line or a recording medium in which the process recipes are recorded, or the input/output device of the existing substrate processing apparatus may be operated to change the process recipes of the existing substrate processing apparatus to the process recipes according to the present disclosure.

The above-described embodiments and modifications may be used in appropriate combination. Processing procedures and processing conditions in such a case may be the same as those of the above-described embodiments and modifications.

The embodiments of the present disclosure are specifically described above. However, the present disclosure is not limited to the above-described embodiments, and various changes may be made without departing from the gist thereof.

### EXPLANATION OF REFERENCE NUMERALS

10: Substrate processing apparatus, 121: Controller, 200: Wafer (substrate), 201: Process chamber.

## Claims

1. A method of processing a substrate, comprising:
(a) supplying a precursor to a substrate;
(b) supplying a reactant to the substrate;
(c) supplying a regulating agent, which regulates an amount of at least one selected from the group of a molecule of the precursor and a molecule of the reactant adsorbed on the substrate, to the substrate;
(d) performing a process in which at least one selected from the group of (a) and (b) overlaps (c); and
(e) after (d), performing (a) or (b) which overlaps (c) in (d), independently of (c).

2. The method of Claim 1, wherein in (d), (a) and (c) are overlapped, and
wherein in (e), (a) is performed independently.

3. The method of Claim 2, wherein (e) is performed after (d).

4. The method of Claim 3, further comprising a process in which (c) is performed before (d).

5. The method of Claim 3, further comprising a process in which (a) is performed before (d).

6. The method of Claim 2, wherein (d) is performed after (e).

7. The method of Claim 6, further comprising a process in which (c) is performed after (d).

8. The method of Claim 1, wherein in (d), (b) and (c) are overlapped, and
wherein in (e), (b) is performed.

9. The method of Claim 8, wherein (e) is performed after (d).

10. The method of Claim 9, further comprising a process in which (c) is performed before (d).

11. The method of Claim 10, further comprising a process in which (b) is performed before (d).

12. The method of Claim 8, wherein (d) is performed after (e).

13. The method of Claim 12, further comprising a process in which (c) is performed after (d).

14. The method of any one of Claims 1 to 13, wherein the precursor contains halogen.

15. The method of any one of Claims 1 to 13, wherein the reactant is a reducing gas.

16. The method of any one of Claims 1 to 13, wherein the regulating agent contains halogen.

17. A method of manufacturing a semiconductor device, comprising:
(a) supplying a precursor to a substrate;
(b) supplying a reactant to the substrate;
(c) supplying a regulating agent, which regulates an amount of at least one selected from the group of a molecule of the precursor and a molecule of the reactant adsorbed on the substrate, to the substrate;
(d) performing a process in which at least one selected from the group of (a) and (b) overlaps (c); and
(e) after (d), performing (a) or (b) which overlaps (c) in (d), independently of (c).

18. A program that causes, by a computer, a substrate processing apparatus to perform a process comprising:
(a) supplying a precursor to a substrate;
(b) supplying a reactant to the substrate;
(c) supplying a regulating agent, which regulates an amount of at least one selected from the group of a molecule of the precursor and a molecule of the reactant adsorbed on the substrate, to the substrate;
(d) performing a process in which at least one selected from the group of (a) and (b) overlaps (c); and
(e) after (d), performing (a) or (b) which overlaps (c) in (d), independently of (c).

19. A substrate processing apparatus, comprising:
a precursor supply system configured to supply a precursor to a substrate;
a reactant supply system configured to supply a reactant to the substrate;
a regulating agent supply system configured to supply a regulating agent to the substrate; and
a controller configured to be capable of controlling the precursor supply system, the reactant supply system, and the regulating agent supply system so as to perform a process including:
(a) supplying the precursor to the substrate;
(b) supplying the reactant to the substrate;
(c) supplying the regulating agent, which regulates an amount of at least one selected from the group of a molecule of the precursor and a molecule of the reactant adsorbed on the substrate, to the substrate;
(d) performing a process in which at least one selected from the group of (a) and (b) overlaps (c); and
(e) after (d), performing (a) or (b) which overlaps (c) in (d), independently of (c).
